# EUROPEAN PATENT APPLICATION

(11) **EP 3 546 272 A1**
(43) Date of publication of application: **02.10.2019**
(21) Application number: 17873352.3
(22) Date of filing: 27.11.2017
(51) Int. Cl.: B60L 3/00, H02M 7/48

(54) **POWER CONVERSION DEVICE FOR RAILWAY VEHICLE**

(30) Priority: 28.11.2016 JP 2016230292
(71) Applicant: Hitachi, Ltd., Tokyo 100-8280 (JP)
(72) Inventor: FUNAKOSHI, Sunao, Tokyo 100-8280 (JP); YASUDA, Yosuke, Tokyo 100-8280 (JP); NISHIHARA, Atsuo, Tokyo 100-8280 (JP); SUZUKI, Osamu, Tokyo 100-8280 (JP); TERAKADO, Shuichi, Tokyo 100-8280 (JP); HORIUCHI, Keisuke, Tokyo 100-8280 (JP); TANAKA, Takeshi, Tokyo 100-8280 (JP)
(74) Representative: Mewburn Ellis LLP
(86) International application number: PCT/JP2017/042321
(87) International publication number: WO 2018/097271

(57) **Abstract**

A cooling performance of a power conversion device mounted in a rail vehicle is improved. A power conversion device for railway vehicle includes a plurality of power semiconductor elements and a heat-receiving member. The power conversion device has a surface on one side of the heat-receiving member on which the plurality of power semiconductor elements are mounted. The power conversion device has a configuration in which the heat-receiving member is installed in a lower portion of a vehicle body and in a horizontal direction, the power semiconductor elements are disposed on an upper side of the heat-receiving member, the heat-receiving member has a surface on an opposite side on which a heat dissipation unit made of a self-excited oscillation heat pipe is installed, and a wind generated by traveling of the vehicle is taken into the heat-receiving member.

## Description

### Technical Field

The present invention relates to a power conversion device for railway vehicle.

### Background Art

A power conversion device is to control an electric motor that drives a vehicle, such as an electric rail vehicle. The power conversion device is installed under a floor of the vehicle or similar place.

A space under the floor of the vehicle or similar place is limited. In view of this, it is preferred that a cooling structure in a size as small as possible efficiently cools power semiconductor elements of the power conversion device.

In a conventional power conversion device for railway vehicle, as described in Japanese Unexamined Patent Application Publication No. 2011-50166 (Patent Literature 1), there is known a structure in which a heat-receiving member is installed in a lower portion of a vehicle body and in a vertical direction, the heat-receiving member has one surface side on which power semiconductor elements are mounted, and the heat-receiving member has an opposite surface side on which a heat pipe is mounted. A wind generated by traveling of a vehicle hits a fin disposed on the heat pipe to dissipate a heat of the power semiconductor elements in the air.

As a cooler to effectively cool a heating element in a small space, there is an automatic oscillating heat pipe in which a self-excited oscillation heat pipe is applied to cool semiconductors. As such an example, there is known a cooling structure of a top heat where the self-excited oscillation heat pipe is directly attached in a lower portion of heating elements as described in Japanese Unexamined Patent Application Publication No. 2013-194919 (Patent Literature 2) .

### Citation List

### Patent Literature

Patent Literature 1: Japanese Unexamined Patent Application Publication No. 2011-50166
Patent Literature 2: Japanese Unexamined Patent Application Publication No. 2013-194919

### Summary of Invention

### Technical Problem

The inventors have seriously studied about downsizing a cooling system in a power conversion device for railway vehicle to improve efficiency, resulting in obtaining the following knowledge.

The power conversion device for railway vehicle is sometimes not allowed to have much height under a floor, for example, as in a part of subway vehicles. In such a vehicle, when power semiconductor elements are disposed on a heat-receiving member in a vertical direction as in the prior art (Patent Literature 1), there has been a case where a height determined by a size of the element becomes too high. As a method to correct this problem, the heat-receiving member is horizontally installed, the power semiconductor elements are installed on an upper side of the heat-receiving member, and a cooler is installed on a lower side of the heat-receiving member. This is considered that a height of the power conversion device can be reduced. However, with a conventional heat pipe cooler, a condensate inside the heat pipe refluxes by gravity. Therefore, what is called a top heat arrangement, where a heat dissipation unit is installed in a lower side with respect to the heat-receiving member, could not be made. While a plate fin can be disposed on the heat-receiving member, a cooling performance is small compared with the heat pipe, and therefore, there has been a problem of necessity of increasing a size.

Meanwhile, in the prior art (Patent Literature 2) in which the self-excited oscillation heat pipe cools the power semiconductor elements in the top heat arrangement, the structure has not been appropriate for reducing a height of the power conversion device when the power conversion device is applied to a vehicle or for a rail vehicle that considers taking in a traveling air.

The object of the present invention is to provide a structure that can reduce a height of a power conversion device and can take in a traveling air to effectively cool power semiconductor elements. Solution to Problem

In order to achieve the object, one of the representative power conversion devices of the present invention includes:
a plurality of power semiconductor elements; and
a heat-receiving member,
wherein the power conversion device for railway vehicle has a surface on one side of the heat-receiving member on which the plurality of power semiconductor elements are mounted, the power conversion device has a configuration in which:
   the heat-receiving member is installed in a lower portion of a vehicle body of a vehicle and in a horizontal direction and/or a vertical direction,
   the power semiconductor elements are disposed on one side of the heat-receiving member,
   the heat-receiving member has a surface on another and opposite side, a heat dissipation unit made of a self-excited oscillation heat pipe being installed on the surface, and
   a wind generated by traveling of a vehicle is taken into the heat-receiving member.

One of the representative power conversion devices of the present invention includes:
a power conversion device a plurality of power semiconductor elements; and
a heat-receiving member,
wherein the power conversion device for railway vehicle has a surface on one side of the heat-receiving member on which the plurality of power semiconductor elements are mounted, in the power conversion device:
   the heat-receiving member is installed in a lower portion of a vehicle body and in a vertical direction,
   the surface of the heat-receiving member on an opposite side of the power semiconductor element includes:
      a plurality of self-excited oscillation heat pipes configuring a flow passage perpendicular to the heat-receiving member, and
      a fin installed between the self-excited oscillation heat pipes,
   a clearance is provided between the plurality of self-excited oscillation heat pipes, and
   an opening is provided in an upper portion and a lower portion of the fin corresponding to a position of the clearance. Advantageous Effects of Invention

With the present invention, while a height of a power conversion device is kept low, power semiconductor elements can be effectively cooled.

Other problems, configurations, and effects than described above will be made apparent from the following descriptions of embodiments.

### Brief Description of Drawings

Fig. 1 is a drawing when a cooling system of a power conversion device according to an embodiment is viewed in a direction of travel.
Fig. 2 is a perspective view of the cooling system of the power conversion device in one embodiment of the present invention.
Fig. 3 is a drawing illustrating an exemplary arrangement of power semiconductor elements on a heat-receiving member of the power conversion device in the one embodiment of the present invention.
Fig. 4 is a drawing illustrating an exemplary arrangement of the power semiconductor elements on the heat-receiving member of the power conversion device in the one embodiment of the present invention.
Fig. 5 is a drawing illustrating a structure of a flow passage of a self-excited oscillation heat pipe disposed in the power conversion device in the one embodiment of the present invention.
Fig. 6 is a drawing illustrating a cross-sectional structure of the self-excited oscillation heat pipe disposed in the power conversion device in the one embodiment of the present invention.
Fig. 7 is a drawing illustrating an exemplary structure when the self-excited oscillation heat pipe disposed in the power conversion device in the one embodiment of the present invention is divided.
Fig. 8 is a drawing illustrating the exemplary structure when the self-excited oscillation heat pipe disposed in the power conversion device in the one embodiment of the present invention is divided.
Fig. 9 is a drawing illustrating another structure of the flow passage of the self-excited oscillation heat pipe disposed in the power conversion device in the one embodiment of the present invention.
Fig. 10 is a drawing illustrating a dividing method for the self-excited oscillation heat pipe disposed in the power conversion device in the one embodiment of the present invention.
Fig. 11 is a drawing illustrating a state where the power conversion device of the present invention is installed in a rail vehicle.
Fig. 12 is a drawing illustrating a configuration of a power conversion device in another embodiment (second embodiment) of the present invention.
Fig. 13 is a drawing illustrating a configuration of a power conversion device in yet another embodiment (third embodiment) of the present invention.
Fig. 14 is a drawing illustrating a state where the power conversion device according to the third embodiment of the present invention is installed in a rail vehicle.
Fig. 15 is a drawing illustrating a structure of a cooling system of a power conversion device in another embodiment (fourth embodiment) of the present invention.
Fig. 16 is a drawing illustrating a state where the power conversion device in the fourth embodiment of the present invention is installed in a rail vehicle.
Fig. 17 is a perspective view illustrating a structure of a cooling system of a power conversion device in another embodiment (fifth embodiment) of the present invention.
Fig. 18 is a perspective view of fins of the cooling system of the power conversion device in the fifth embodiment of the present invention.

### Description of Embodiments

The following describes embodiments of the present invention with reference to the drawings.

### [Embodiment 1]

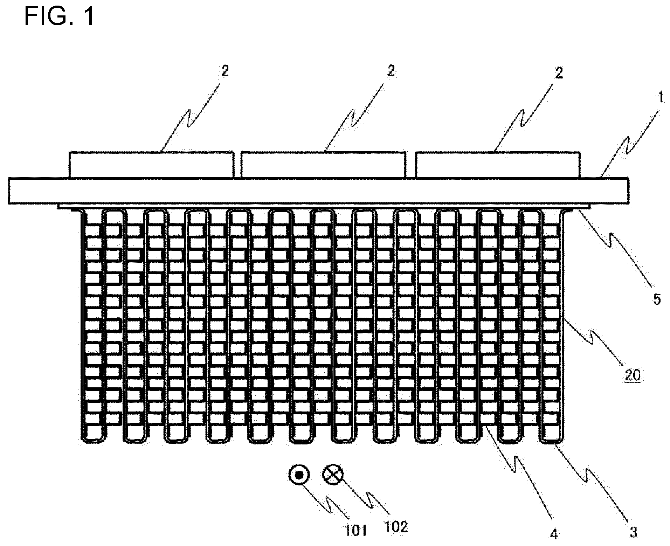

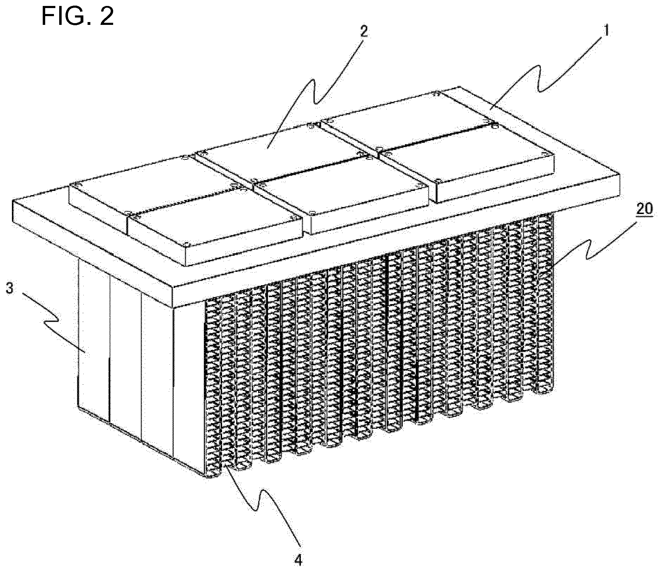

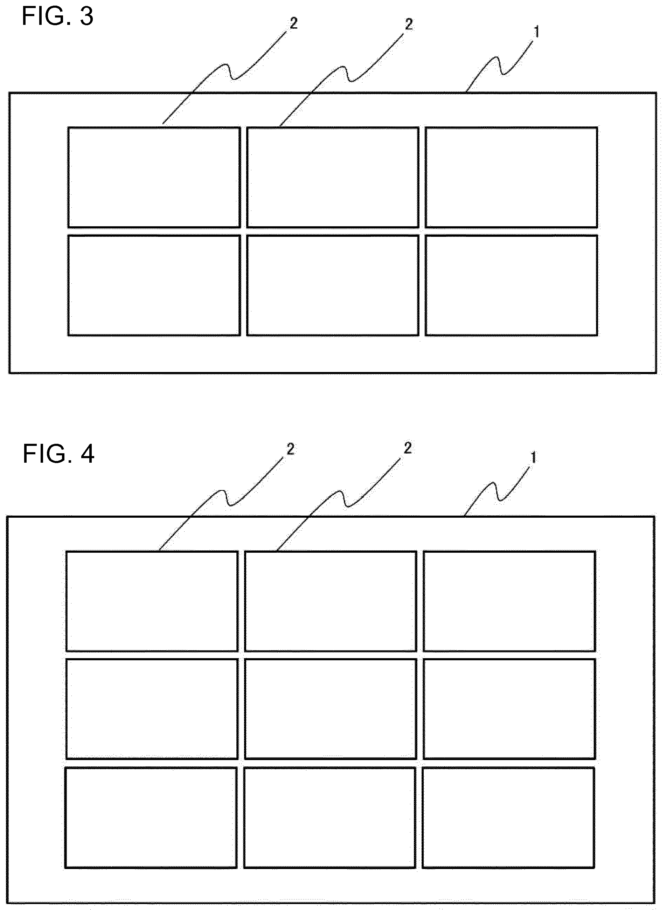

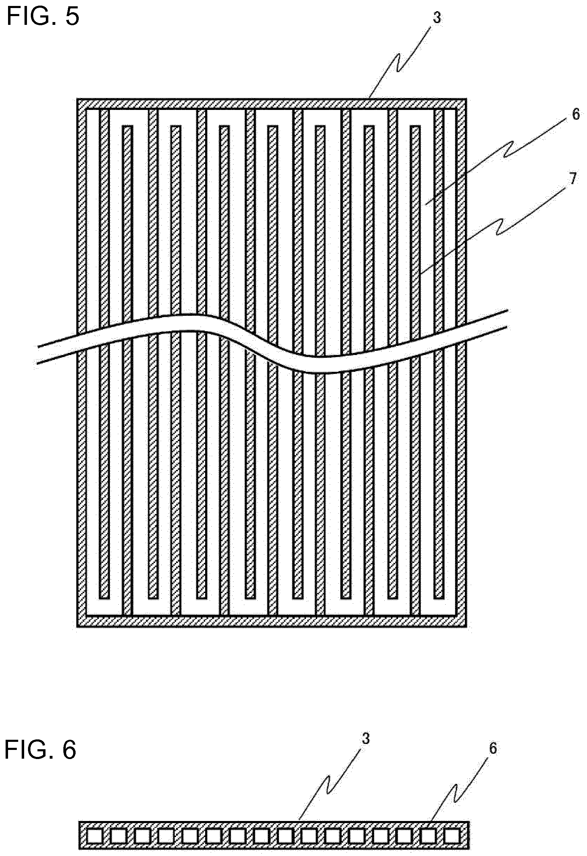

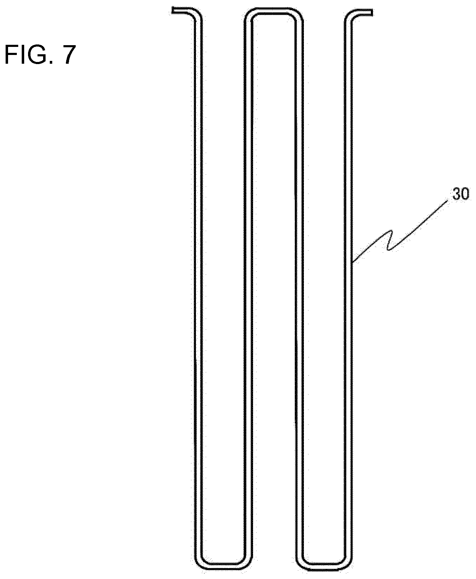

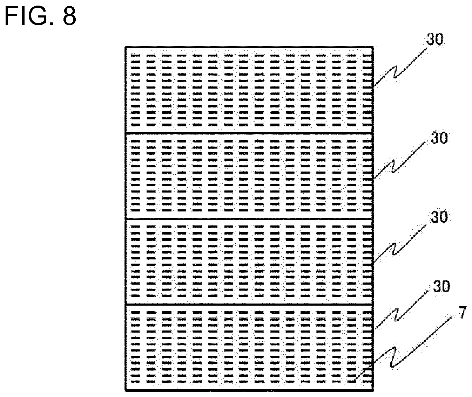

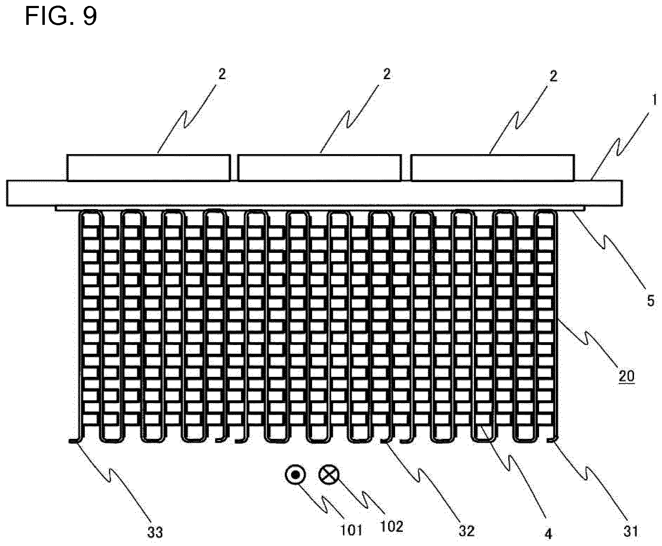

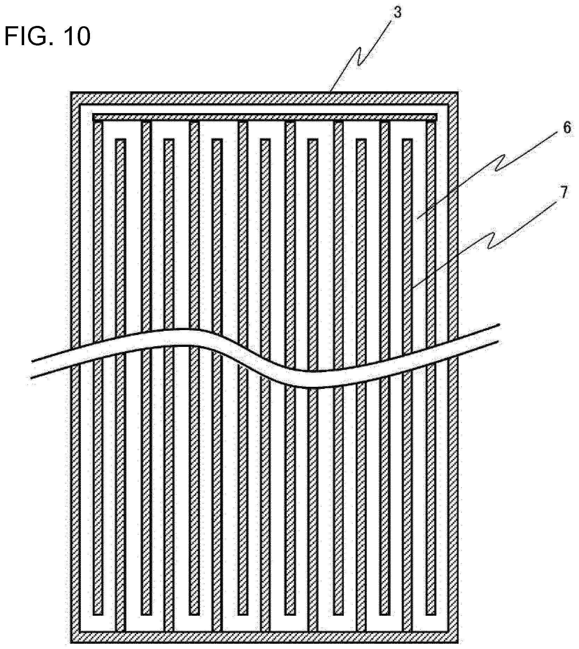

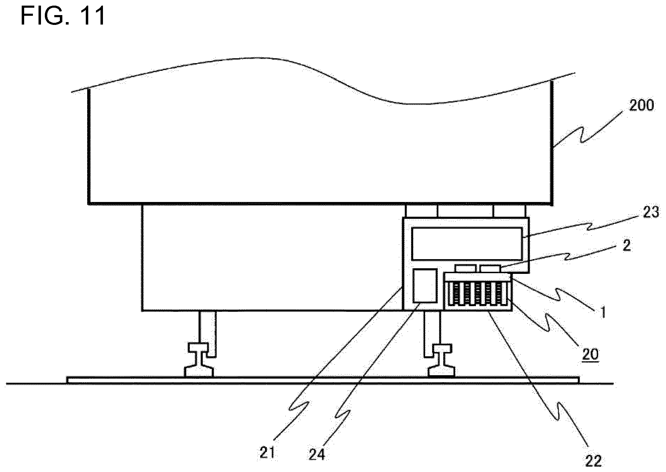

Fig. 1 to Fig. 10 are drawings illustrating one embodiment of the present invention. Fig. 1 is a front view where a portion of a cooling system of a power conversion device is viewed in a direction of travel. Fig. 2 is a perspective view of it. Fig. 3 and Fig. 4 are drawings illustrating exemplary arrangements of power semiconductor elements on a heat-receiving member of the power conversion device of the present invention. Fig. 5 is a drawing illustrating a structure of a flow passage of a self-excited oscillation heat pipe disposed in the power conversion device of the present invention. Fig. 6 is a drawing illustrating its cross-sectional view. Fig. 7 and Fig. 8 are drawings illustrating an exemplary structure when the self-excited oscillation heat pipe is divided. Fig. 9 is a drawing illustrating another structure of a flow passage of the self-excited oscillation heat pipe. Fig. 10 is a drawing illustrating a dividing method for the self-excited oscillation heat pipe. Fig. 11 is a block diagram illustrating a state when the power conversion device in the one embodiment of the present invention (first embodiment) is installed in a rail vehicle.

A power conversion device of the present invention is disposed under a floor of a vehicle body or similar place of a rail vehicle (hereinafter referred to as a vehicle) 200 as illustrated in Fig. 11. By changing a frequency of an electric power supplied to an electric motor (not illustrated) that drives the vehicle 200, the power conversion device controls a rotation speed of the electric motor.

In Fig. 11, the power conversion device including power semiconductor elements (power semiconductor modules) 2 is, for example, secured in a state of being suspended in a bottom portion of a vehicle body of the vehicle 200.

The following describes respective configurations of the power conversion device including the power semiconductor elements (power semiconductor modules) 2 and a cooling system that is mounted in the power conversion device to cool the power semiconductor elements (power semiconductor modules) 2.

First, In Fig. 1, arrows 101 and 102 indicate a direction of a traveling air generated by the vehicle (see Fig. 11) traveling in a direction of travel.

The vehicle moves in both forward and rearward directions, and in accordance with this, a traveling air is generated in any one of the directions of the arrows 101 and 102.

The cooling system includes a heat-receiving member 1 and a heat dissipation unit 20 (self-excited oscillation heat pipes 3 and 5, and waveform fins 4).

The heat-receiving member 1 is made of metal, such as aluminum alloy, steel, and copper.

The heat-receiving member 1 has an upper side on which the power semiconductor modules 2 including the power semiconductor elements of, for example, the power conversion device, that is, a plurality of IGBT (Insulated Gate Bipolar Transistors) are installed.

A plurality of the power semiconductor modules 2 configure the power conversion device. Hereinafter, these power semiconductor modules are referred to as the power semiconductor elements.

The power semiconductor elements 2 are secured on one surface (upper surface) of the heat-receiving member 1 with, for example, screws (not illustrated) via a member (not illustrated) such as a grease.

Exemplary arrangements of the power semiconductor elements 2 on the heat-receiving member 1 are illustrated in Fig. 3 and Fig. 4. As illustrated in the drawings, a plurality of the power semiconductor elements 2 are usually aligned and arranged.

In one side (upper side in drawing) of the power semiconductor elements 2 of the heat-receiving member 1, a sealed casing (inverter box) 21 is disposed as illustrated in Fig. 11. Inside this casing, electric components 23 and 24, such as a filter condenser and an IGBT driver circuit, are installed.

In an opposite side (lower side in drawing) of a power semiconductor element installation surface of the heat-receiving member 1, the heat dissipation unit 20 is disposed.

The heat dissipation unit 20 is configured of, for example, the self-excited oscillation heat pipe 3 (first automatic oscillation heat pipe), the fins (for example, waveform fins) 4 made of, for example, aluminum alloy, and the self-excited oscillation heat pipe 5 (second automatic oscillation heat pipe).

The heat-receiving member 1 and the second self-excited oscillation heat pipe 5, the second self-excited oscillation heat pipe 5 and the self-excited oscillation heat pipe 3, and the self-excited oscillation heat pipe 3 and the waveform fins 4, are each secured by, for example brazing.

The self-excited oscillation heat pipe 3 illustrated in Fig. 1 is configured by folding a plate-shaped self-excited oscillation heat pipe in which a working fluid is sealed. The example is illustrated in Fig. 5.

The self-excited oscillation heat pipe 3 includes a flow passage (working body flow passage) 6 for the working fluid that meanders as illustrated in Fig. 5 and partition portions 7. Fig. 6 illustrates a cross section of the self-excited oscillation heat pipe 3.

As the working fluid, for example, water, Fluorinerts, alternative CFCs, alcohols, hydrocarbons such as butane, hydrofluoroethers, and perfluoroketones are used.

The heat-receiving member 1, the second self-excited oscillation heat pipe 5, and the first self-excited oscillation heat pipe are joined in the order from the heat-receiving member 1, the first self-excited oscillation heat pipe 3, and the second self-excited oscillation heat pipe 5 from the top as illustrated.

Next, an operation of the cooling system according to the embodiment will be described.

A loss generated by operations of the power semiconductor elements 2 becomes a heat.

The heat generated from the power semiconductor elements 2 is transmitted to the self-excited oscillation heat pipe 3 through the heat-receiving member 1 and the second self-excited oscillation heat pipe 5.

The working fluid sealed in the flow passage 6 for the working fluid of the self-excited oscillation heat pipe 3 illustrated in Fig. 5 oscillates in the flow passage, and thus, the heat is transmitted to a distal end portion of the self-excited oscillation heat pipe 3.

Furthermore, the heat is transmitted from the self-excited oscillation heat pipe 3 to the waveform fins 4, and the traveling airs 101 and 102 generated by the vehicle traveling pass between the fins 4. Thus, the heat is dissipated from surfaces of the fins 4 and the self-excited oscillation heat pipes 3 into the air.

Meanwhile, the second self-excited oscillation heat pipe 5 includes the flow passage 6 for the working fluid in the direction of travel of the vehicle 200, and plays a role to enhance a cooling effect by uniformizing temperatures of the power semiconductor elements 2 in windward side and in leeward side.

Here, in order to adjust a length of the flow passage 6 for the working fluid such that the self-excited oscillation heat pipe 3 efficiently operates, the self-excited oscillation heat pipe 3 may be divided into a plurality of portions in the heat dissipation unit 20.

Fig. 7 and Fig. 8 illustrate an exemplary structure (bubble-actuated heat pipe 30) when the self-excited oscillation heat pipe 3 is divided. Fig. 7 illustrates an example of a division unit in a direction perpendicular to the traveling air. Fig. 8 illustrates an example of the division unit in a direction of the traveling air.

Fig. 9 is an example illustrating another dividing method for the self-excited oscillation heat pipe 3.

In this example, the self-excited oscillation heat pipe 3 is divided into three, self-excited oscillation heat pipes 31, 32, and 33.

A working fluid sealed portion may be mounted on a divided portion on a distal end side of the self-excited oscillation heat pipe 3.

The second self-excited oscillation heat pipe 5 may be divided similarly to Fig. 8 to adjust a flow-passage length of the working fluid.

An opening may be disposed at upper and lower portions of the fin 4 corresponding to a position of a clearance generated between a plurality of the self-excited oscillation heat pipes 3 and 5.

Fig. 10 is a drawing illustrating a case where the self-excited oscillation heat pipes 3 and 5 whose flow passage 6 for the working fluid of the self-excited oscillation heat pipe 3 is configured into a loop shape are applied.

Thus configuring the flow passage 6 for the working fluid into the loop shape further effectively achieves a heat move in the self-excited oscillation heat pipes 3 and 5.

The configuration of the embodiment ensures keeping a height of the power conversion device lower than when the power semiconductor elements 2 are disposed in a vertical direction, and taking in the traveling air between the fins 4 disposed on the self-excited oscillation heat pipes 3 and 5 for uniformizing heat ensures effectively cooling the power semiconductor elements.

That is, a cooling performance by the cooling system can be improved and the cooling system can be downsized compared with the conventional one. The structure that causes the wind to pass through in the vertical direction improves the cooling performance while the vehicle stops.

### [Embodiment 2]

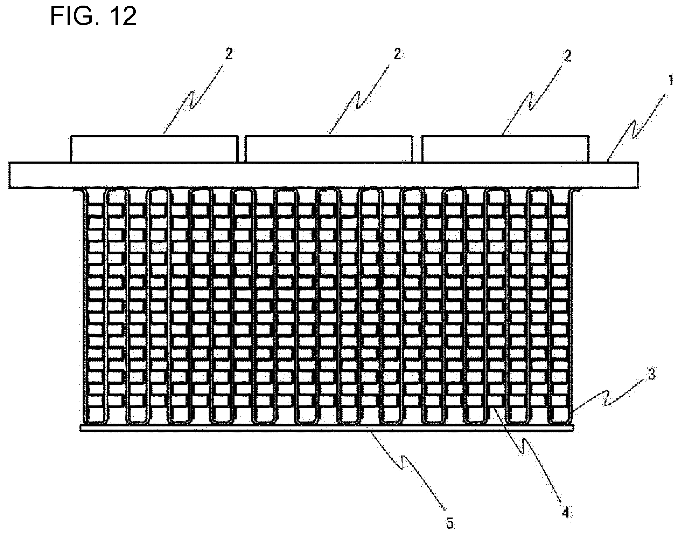

Fig. 12 is a drawing illustrating a structure of a power conversion device in another embodiment (second embodiment) of the present invention.

In the following drawings, portions identical to those in the first embodiment are indicated by identical numbers and their detailed descriptions will be omitted.

In this embodiment, as illustrated, the self-excited oscillation heat pipe 3 has one side (upper side) joined on the heat-receiving member 1, and the second self-excited oscillation heat pipe 5 is disposed on an opposite side (lower side) of the self-excited oscillation heat pipe 3.

The heat-receiving member 1, the first self-excited oscillation heat pipe 3, and the second self-excited oscillation heat pipe 5 are unlike the embodiment in Fig. 1, the heat-receiving member 1, the first self-excited oscillation heat pipe 3, and the second self-excited oscillation heat pipe 5 are joined in this order from the top as illustrated in the drawing.

Having such a structure ensures a further improved cooling performance by uniformizing the power semiconductor element temperatures in the windward side and in the leeward side. It is also possible to prevent the second self-excited oscillation heat pipe 5 from becoming a thermal resistance.

### [Embodiment 3]

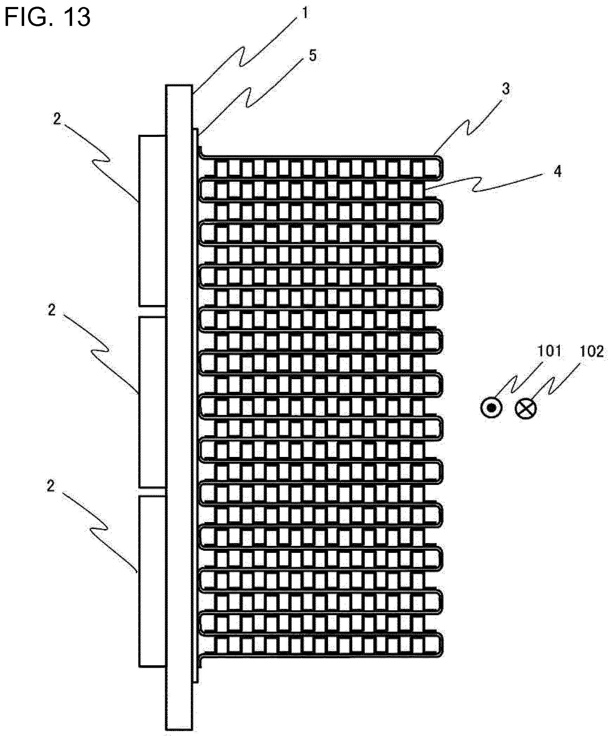

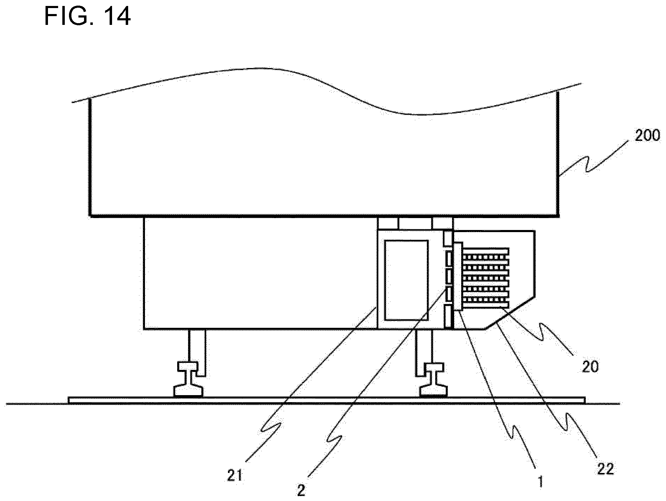

Fig. 13 is a drawing illustrating a structure of a power conversion device in yet another embodiment (third embodiment) of the present invention. Fig. 14 is a drawing illustrating a configuration when the power conversion device is mounted in a rail vehicle.

In the following drawings, portions identical to those in the first and second embodiments are indicated by identical numbers and their detailed description will be omitted.

In this embodiment, an example has the heat-receiving member 1 disposed in the vertical direction and the power semiconductor elements 2 are arranged in the vertical direction. On an opposite side of the power semiconductor elements 2, the self-excited oscillation heat pipe 3 disposed in the horizontal direction, and the waveform fins 4 secured by, for example, brazing between the self-excited oscillation heat pipe 3 are disposed.

Such configuration causes the traveling airs 101 and 102 generated by the vehicle 200 traveling to pass between the waveform fins 4. This dissipates the heat from the surfaces of the waveform fins 4 and the self-excited oscillation heat pipe 3 into the air.

The heat-receiving member 1 has a surface on which the second self-excited oscillation heat pipe 5 is installed by, for example, brazing. The second self-excited oscillation heat pipe 5 has the flow passage disposed in the direction of travel of the vehicle, and plays a role to enhance a cooling effect by uniformizing temperatures of the elements in the windward and in the leeward.

With the embodiment, the traveling air can be taken in between the self-excited oscillation heat pipe 3 disposed in the horizontal direction and the waveform fins 4, and the element temperatures in the direction of travel of the vehicle can be uniformized by the second self-excited oscillation heat pipe 5, thereby ensuring effectively cooling the power semiconductor elements.

### [Embodiment 4]

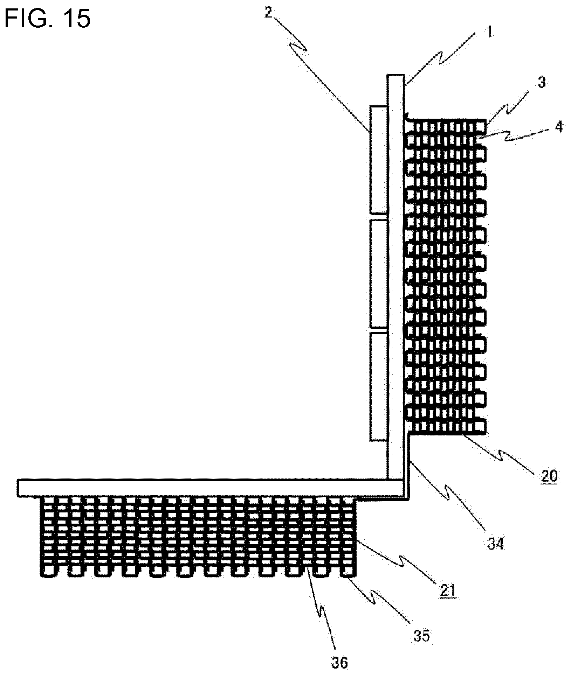

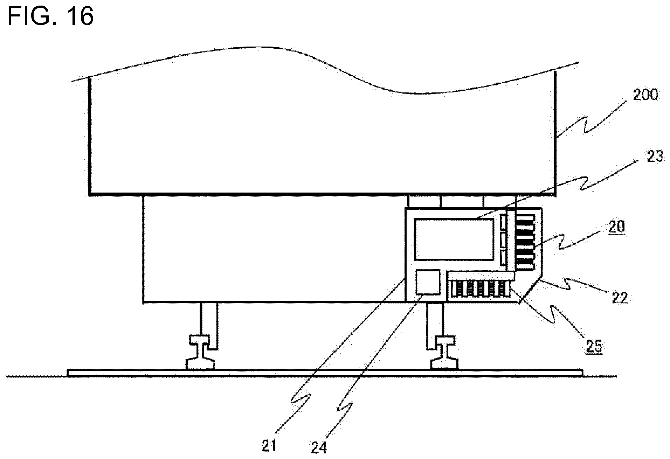

Fig. 15 is a drawing illustrating a structure of a cooling system of a power conversion device in yet another embodiment (fourth embodiment) of the present invention. Fig. 16 is a drawing illustrating a configuration when the cooling system is mounted in a rail vehicle.

In the following drawing, portions identical to those in the first to the third embodiment are indicated by identical numbers and their detailed description will be omitted.

In this embodiment, the inverter box 21 has a side surface and a bottom surface on which the heat dissipation unit 20 and a heat dissipation unit 25 are disposed, respectively. The heat dissipation units 20 and 25 are configured of the respective self-excited oscillation heat pipes 3 and are connected by a self-excited oscillation heat pipe connecting portion 34 on the side surface and the bottom surface.

With the embodiment, effectively using the side surface and the bottom surface of the inverter box 21 as the heat dissipation units 20 ensures obtaining an enough heat dissipation area even with the thin heat dissipation unit 20, thereby ensuring downsizing the whole inverter box.

### [Embodiment 5]

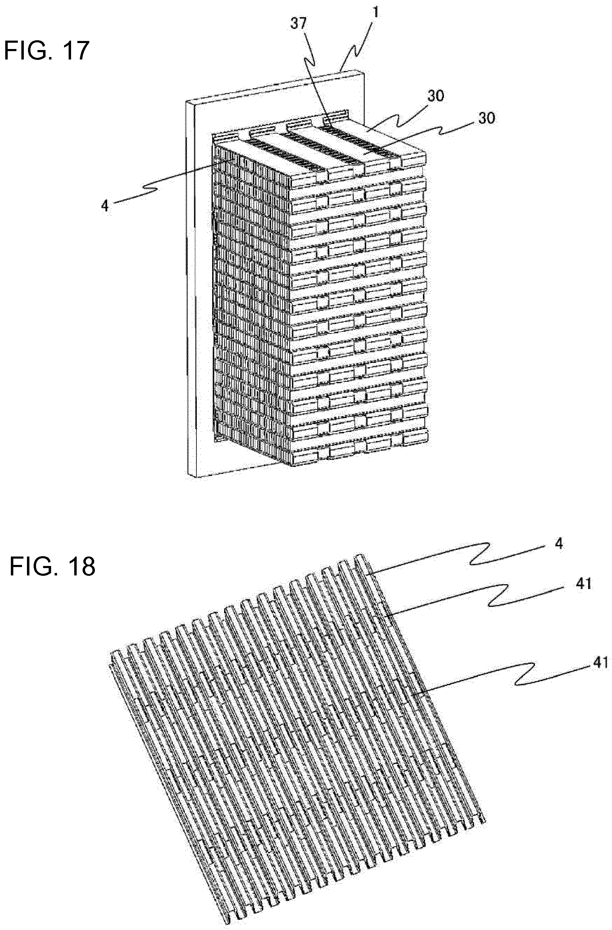

Fig. 17 is a drawing illustrating a structure of a cooling system of a power conversion device in yet another embodiment (fifth embodiment) of the present invention. Fig. 18 is a drawing illustrating a structure of waveform fins in the cooling system.

In the following drawing, portions identical to those in the first to the fourth embodiment are indicated by identical numbers and their detailed description will be omitted.

In the embodiment, clearances 37 are provided between a plurality of the bubble-actuated heat pipes 30. Meanwhile, the waveform fins 4 installed between the bubble-actuated heat pipes 30 are provided with hole portions 41 as illustrated in Fig. 18.

Positions of the hole portions 41 are located to correspond to positions of the clearances 37 after assembly such that the air flows in the vertical direction through portions of the clearances 37.

Such a structure causes the air to flow in the vertical direction of the clearance 37 portions by a natural convection while the vehicle stops, thereby ensuring an enhanced cooling effect during the vehicle stop.

As described above, with each of the embodiments, the heat-receiving member is installed in the lower portion of the vehicle body and in the horizontal direction, the power semiconductor elements are disposed on the upper side of the heat-receiving member, and the heat dissipation unit made of the self-excited oscillation heat pipe is installed on the surface on the opposite side of the heat-receiving member. This ensures keeping the height of the power conversion device lower than when the power semiconductor elements are disposed in the vertical direction and ensures effectively cooling the power semiconductor elements by taking in the traveling air between the fins disposed on the self-excited oscillation heat pipe.

The present invention is not limited to the above-described embodiments, and various modifications are included. For example, the above-described embodiments are detailed descriptions to describe the present invention to be easily understood, and it is not necessarily limited to one that includes all the described configurations. A configuration of another embodiment can be added, deleted, and replaced for a part of the configurations of the embodiments.

### List of Reference Signs

- 1: heat-receiving member
- 2: power semiconductor element (power semiconductor module)
- 3: first self-excited oscillation heat pipe
- 4: fin (waveform fin)
- 5: second self-excited oscillation heat pipe
- 6: flow passage for working fluid
- 7: partition portion
- 20: heat dissipation unit
- 21: casing (inverter box)
- 23, 24: electric component
- 200: rail vehicle (vehicle body)

## Claims

1. A power conversion device for railway vehicle, comprising:
a plurality of power semiconductor elements; and
a heat-receiving member,
wherein the power conversion device has a surface on one side of the heat-receiving member on which the plurality of power semiconductor elements are mounted, the power conversion device has a configuration in which:
the heat-receiving member is installed in a lower portion of a vehicle body of a vehicle and in a horizontal direction and/or a vertical direction,
the power semiconductor elements are disposed on a surface on one side of the heat-receiving member,
the heat-receiving member has an opposite surface on another side, a heat dissipation unit made of a self-excited oscillation heat pipe being installed on the opposite surface, and
a wind generated by traveling of the vehicle is taken into the heat dissipation unit.

2. The power conversion device according to claim 1,
wherein the surface on the one side of the heat-receiving member is a vehicle body side of the vehicle, and the opposite surface on the other side of the heat-receiving member is a non-vehicle body side,
the self-excited oscillation heat pipe includes:
a first self-excited oscillation heat pipe including a flow passage in a direction perpendicular to the heat-receiving member, and
a second self-excited oscillation heat pipe including a flow passage parallel to the heat-receiving member and parallel to a direction of travel of the vehicle, and
the heat-receiving member, the second self-excited oscillation heat pipe, and the first self-excited oscillation heat pipe are joined in this order, or the heat-receiving member, the first self-excited oscillation heat pipe, and the second self-excited oscillation heat pipe are joined in this order.

3. The power conversion device according to claim 2,
wherein the first self-excited oscillation heat pipe and/or the second self-excited oscillation heat pipe is divided and formed, and a flow passage is configured into a loop shape.

4. The power conversion device according to claim 2,
wherein the first self-excited oscillation heat pipe and the second self-excited oscillation heat pipe are connected.

5. The power conversion device according to claim 1,
wherein the heat-receiving member includes:
a first heat-receiving member installed in a horizontal direction and a second heat-receiving member installed in a vertical direction in the lower portion of the vehicle,
the first heat-receiving member has a surface on one side that is a vehicle body side of the vehicle, the heat-receiving member has an opposite surface on another side that is a non-vehicle body side, and
the second heat-receiving member has a surface on one side that is a vehicle body side of the vehicle, the second heat-receiving member has an opposite surface on another side that is a non-vehicle body side,
the self-excited oscillation heat pipe is configured of a first and second self-excited oscillation heat pipes including flow passages in a direction perpendicular to the first and second heat-receiving members on a side surface and a bottom surface of an inverter box of the power conversion device, and
the first and second self-excited oscillation heat pipes are connected at a self-excited oscillation heat pipe connecting portion of the self-excited oscillation heat pipe 3.

6. The power conversion device according to any one of claims 2 to 4,
wherein the second self-excited oscillation heat pipe includes a waveform fin.

7. The power conversion device according to claim 1,
wherein the heat-receiving member is installed in a lower portion of a vehicle body and in a vertical direction,
the self-excited oscillation heat pipe is disposed on a surface on an opposite side of the power semiconductor element of the heat-receiving member, and
the self-excited oscillation heat pipe includes:
a first self-excited oscillation heat pipe configuring a flow passage perpendicular to the heat-receiving member, and
a second self-excited oscillation heat pipe configuring a flow passage in a vertical direction in a position under the first self-excited oscillation heat pipe.

8. The power conversion device according to any one of claims 2 to 6,
wherein the first self-excited oscillation heat pipe and the second self-excited oscillation heat pipe are configured divided into a plurality of flow passages.

9. The power conversion device according to claim 1,
wherein the heat-receiving member is installed in a lower portion of a vehicle body and in a vertical direction,
the surface of the heat-receiving member on the opposite side of the power semiconductor element includes:
a plurality of self-excited oscillation heat pipes configuring a flow passage perpendicular to the heat-receiving member, and
a fin installed between the self-excited oscillation heat pipes,
a clearance is provided between the plurality of self-excited oscillation heat pipes, and
an opening is provided in an upper portion and a lower portion of the fin corresponding to a position of the clearance.
